(19) Europäisches Patentamt / European Patent Office / Office européen des brevets

(11) **EP 4 786 996 A1**

(12) **EUROPEAN PATENT APPLICATION**
published in accordance with Art. 153(4) EPC

(43) Date of publication:
**05.08.2026 Bulletin 2026/32**

(21) Application number: **25817740.1**

(22) Date of filing: **28.04.2025**

(51) International Patent Classification (IPC):
**G01R 31/392** (2019.01)   **G01R 31/367** (2019.01)

(52) Cooperative Patent Classification (CPC):
Y02E 60/10

(86) International application number:
**PCT/CN2025/091752**

(87) International publication number:
**WO 2026/118363 (11.06.2026 Gazette 2026/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:   **06.12.2024   CN 202411785131**

(71) Applicant: **Lbatterycloud Co. Ltd.**
**Yantai, Shandong 264000 (CN)**

(72) Inventors:
 • **CI, Song**
   **Yantai, Shandong 264004 (CN)**
 • **ZHANG, Ming**
   **Yantai, Shandong 264004 (CN)**

 • **LI, Chaofan**
   **Yantai, Shandong 264004 (CN)**
 • **LI, Kai**
   **Yantai, Shandong 264004 (CN)**
 • **LI, Xuefeng**
   **Yantai, Shandong 264004 (CN)**
 • **WANG, Yunfang**
   **Yantai, Shandong 264004 (CN)**
 • **BAI, Xuheng**
   **Yantai, Shandong 264004 (CN)**
 • **LIU, Hongye**
   **Yantai, Shandong 264004 (CN)**

(74) Representative: **Chung, Hoi Kan**
   **Mandarin IP Limited**
   **7 Cherry Trees**
   **Great Shelford**
   **Cambridge CB22 5XA (GB)**

(54) **MAMBA MODEL-BASED LITHIUM BATTERY LIFE PREDICTION METHOD, AND SYSTEM**

(57)   Disclosed are a Mamba model-based lithium battery lifetime prediction method and system in the technical field of energy storage in renewable energy power systems, the method including: acquiring aging feature matrices of a plurality of lithium batteries and inputting the same into a Mamba model for training, extracting a hidden state matrix sequence of each of the lithium batteries based on the trained Mamba model, and obtaining a cycle count sequence corresponding to a target cycle life prediction point of each of the lithium batteries through norm calculation and variational mode decomposition; constructing a linear relationship model for lithium battery lifetime prediction based on cycle count sequences corresponding to target states of health of all of the lithium batteries and cycle count sequences corresponding to target cycle life prediction points of all of the lithium batteries; and calculating a cycle count sequence corresponding to a target state of health of a to-be-predicted lithium battery based on the linear relationship model for lithium battery lifetime prediction. The present application improves the interpretability and computational efficiency of lithium battery lifetime prediction while expanding the scope of application of the prediction model.

EP 4 786 996 A1

| Acquire aging feature matrices of a plurality of lithium batteries | S1 |

| Input the aging feature matrices of the plurality of lithium batteries into a Mamba model for training, and extract a hidden state matrix sequence of each of the lithium batteries based on the trained Mamba model | S2 |

| Obtain a cycle count sequence corresponding to a target cycle life prediction point of each of the lithium batteries through norm calculation and variational mode decomposition based on the hidden state matrix sequence of each of the lithium batteries | S3 |

| Construct a linear relationship model for lithium battery lifetime prediction based on cycle count sequences corresponding to target states of health of all of the lithium batteries and cycle count sequences corresponding to target cycle life prediction points of all of the lithium batteries | S4 |

| Acquire a cycle count sequence corresponding to a cycle life prediction point of a to-be-predicted lithium battery, and input the same into the linear relationship model for lithium battery lifetime prediction to calculate a cycle count sequence corresponding to a target state of health of the to-be-predicted lithium battery | S5 |

FIG. 1

**Description**

The present application claims priority to Chinese Patent Application No. 202411785131.5, filed with the China National Intellectual Property Administration on December 06, 2024 and entitled "MAMBA MODEL-BASED LITHIUM BATTERY LIFETIME PREDICTION METHOD AND SYSTEM", which is incorporated herein by reference in its entirety.

TECHNICAL FIELD

The present application relates to the technical field of energy storage in renewable energy power systems and, in particular, to a Mamba model-based lithium battery lifetime prediction method and system.

BACKGROUND

With the growth in global energy demand and increasing awareness of environmental protection, renewable energy technologies, particularly lithium battery energy storage technology, are rapidly developing. Since lithium batteries are the core component of an energy storage system, their performance directly affects the stability and economic efficiency of the entire energy storage system. In application scenarios such as renewable energy power generation and electric vehicles, the cycle life of lithium batteries is a key factor determining the operational cost, safety, and stability of the system. However, the cycle life of lithium batteries is influenced by multiple complex factors, including but not limited to charge-discharge current, temperature, state of charge, and cycle count. These factors not only complicate the lifetime prediction of lithium batteries but also increase the difficulty for battery management systems in monitoring and managing battery states. Conventional methods for predicting the cycle life of lithium batteries primarily rely on empirical models or linear models based on single variables, which often struggle to accurately reflect the degradation characteristics of batteries under actual complex operating conditions. With the rise of artificial intelligence and big data technologies, machine learning-based lithium battery lifetime prediction methods have gradually become a research hotspot. By analyzing and modeling large amounts of actual operational data, it is possible to more accurately predict battery degradation trends, thereby enabling scientific management and optimization throughout a battery's entire lifecycle. Accurate methods for predicting the cycle life of lithium batteries can not only help optimize the design and operational strategies for an energy storage system and extend battery service life but also effectively reduce the operational costs of the system, improve the efficiency of renewable energy utilization, and provide crucial support for building a more stable and reliable energy system. Research and technological advancements in this field are of significant importance for promoting the development of renewable energy and energy storage industries.

In some cases, methods for predicting the cycle life of lithium batteries suffer from issues such as an inability to accurately reflect the correspondence between the aging features of lithium batteries and their health state, poor interpretability of lifetime predictions leading to inaccurate results, and limited applicability of prediction models.

SUMMARY

The present application is intended to provide a Mamba model-based lithium battery lifetime prediction method and system, which can improve the interpretability and computational efficiency of lithium battery lifetime prediction while expanding the scope of application of the prediction model.

To achieve the aforementioned objectives, the present application provides the following solutions.

In a first aspect, the present application provides a Mamba model-based lithium battery lifetime prediction method, including the following steps: acquiring aging feature matrices of a plurality of lithium batteries, where the aging feature matrices include: state of health sequences and aging feature sequences, where the state of health sequences are sequences formed by a state of health of each of the lithium batteries at each cycle count; inputting the aging feature matrices of the plurality of lithium batteries into a Mamba model for training, and extracting a hidden state matrix sequence of each of the lithium batteries based on the trained Mamba model; obtaining a cycle count sequence corresponding to a target cycle life prediction point of each of the lithium batteries through norm calculation and variational mode decomposition based on the hidden state matrix sequence of each of the lithium batteries, where the target cycle life prediction point is a prediction point with the highest correlation among candidate cycle life prediction points, where the candidate cycle life prediction points are prediction points in a hidden state matrix norm sequence curve of the lithium batteries obtained after the norm calculation that correlate with a cycle count sequence corresponding to a target state of health of the lithium batteries, where the cycle count sequence corresponding to the target state of health of the lithium batteries is indexed from the state of health sequences; constructing a linear relationship model for lithium battery lifetime prediction based on cycle count sequences corresponding to target states of health of all of the lithium batteries and cycle count sequences corresponding to target cycle life prediction points of all of the lithium batteries; and acquiring a cycle count sequence corresponding to a target cycle life prediction point of a to-be-predicted lithium battery, and inputting the same into the linear relationship model for lithium battery lifetime prediction to calculate a cycle count sequence corresponding to a target state of health of the to-be-predicted lithium battery.

In a second aspect, the present application provides a computer system, including: a memory, a processor, and a computer program stored on the memory and executable on the processor, where the processor executes the computer program to implement the Mamba model-based lithium battery lifetime prediction method of any one of the foregoing.

According to the embodiments provided by the present application, the following technical effects are disclosed.

By inputting the aging feature matrices of lithium batteries into a Mamba model for training and utilizing the trained model to extract the hidden state matrix sequence of each lithium battery, thereby learning the relationship between the aging features and the state of health of batteries from historical time-series data, the present application improves the computational efficiency of the model and consequently enhances the interpretability of lithium battery lifetime prediction; by performing norm calculation, a three-dimensional hidden state matrix sequence is transformed into a one-dimensional hidden state matrix norm sequence, amplifying the temporal variation patterns of internal hidden states during lithium battery aging and improving the representativeness of lifetime prediction; through variational mode decomposition, the principal mode sequence of the hidden state matrix norm for each lithium battery is extracted, reducing interference errors caused by noise and enhancing the robustness of the model; and by analyzing the correlation between the cycle count sequences corresponding to the target states of health of all lithium batteries and the cycle count sequences corresponding to the target cycle life prediction points of all lithium batteries, the cycle life prediction points are determined. This method considers the commonalities among different lithium batteries during the cyclic aging process, and the linear relationship model constructed for lithium battery lifetime prediction based on this method expands the scope of application of the prediction model.

## BRIEF DESCRIPTION OF THE DRAWINGS

To describe the technical solutions in the embodiments of the present application or in the prior art more clearly, the following will briefly introduce the accompanying drawings required for describing the embodiments. Apparently, the accompanying drawings in the following description show merely some embodiments of the present application, and a person of ordinary skill in the art may still derive other accompanying drawings from these accompanying drawings without creative efforts.

FIG. 1 shows a schematic flowchart of a Mamba model-based lithium battery lifetime prediction method according to an embodiment of the present application;

FIG. 2 shows a curve graph of a relationship between cycle count and state of health of a lithium battery according to an embodiment of the present application;

FIG. 3 shows a scatter plot of a relationship between aging features and state of health of a lithium battery according to an embodiment of the present application;

FIG. 4 shows a curve graph of a hidden state matrix norm according to an embodiment of the present application;

FIG. 5 shows a curve graph of a principal mode of a hidden state matrix norm according to an embodiment of the present application;

FIG. 6 shows a correlation curve graph of cycle counts corresponding to target states of health at candidate cycle life prediction points according to an embodiment of the present application;

FIG. 7 shows a fitting result graph of a cycle count corresponding to a target cycle life prediction point versus a cycle count corresponding to a target state of health of 0.8 according to an embodiment of the present application;

FIG. 8 shows a prediction result graph of a to-be-predicted lithium battery at different states of health according to an embodiment of the present application; and

FIG. 9 is a schematic structural diagram of a computer system according to an embodiment of the present application.

## DETAILED DESCRIPTION OF THE EMBODIMENTS

The technical solutions in the embodiments of the present application will be clearly and completely described below with reference to the accompanying drawings in the embodiments of the present application. Apparently, the described embodiments are only some rather than all of the embodiments of the present application. All other embodiments obtained by a person of ordinary skill in the art based on the embodiments of the present application without creative efforts shall fall within the protection scope of the present application.

To make the aforementioned objectives, features, and advantages of the present application more comprehensible, a detailed explanation of the present application will be given below with reference to the accompanying drawings and specific implementation manners.

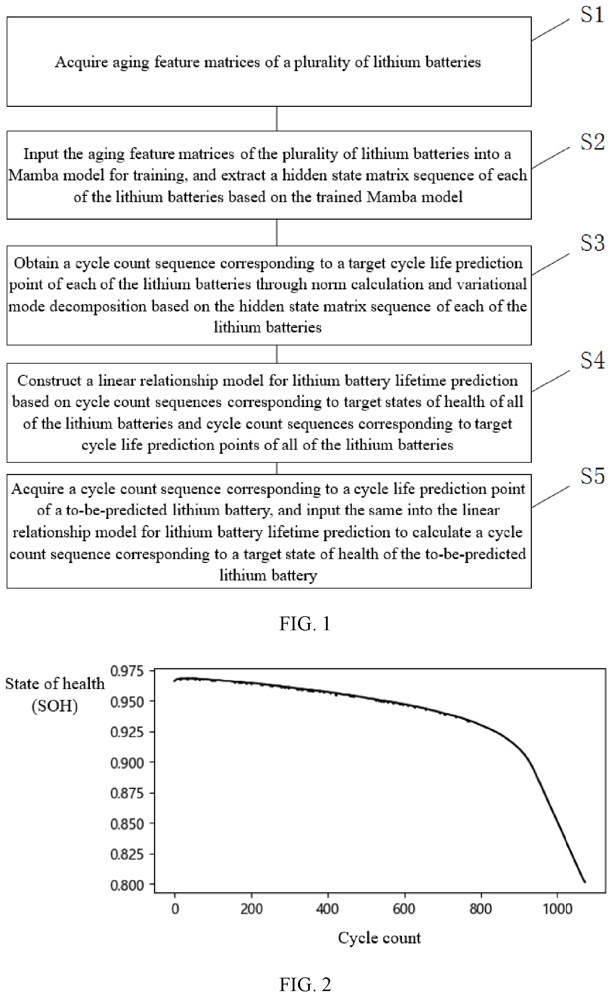

Example 1: as shown in FIG. 1, this example provides a Mamba model-based lithium battery lifetime prediction method, including the following steps.

S1: acquiring aging feature matrices of a plurality of lithium batteries, where the aging feature matrices include: state of health sequences and aging feature sequences, where the state of health sequences are sequences formed by a state of health of each of the lithium batteries at each cycle count. FIG. 2 shows a curve graph of a relationship between cycle count and state of health of a lithium battery.

The step S1 includes the following steps.

S11: acquiring cyclic operation data of the plurality of lithium batteries, where the cyclic operation data at least include: voltage, temperature, capacity change value, and cycle count data at different sampling times. In this example, the voltage data are obtained using a PXI7065 battery data acquisition card; the temperature data are obtained using an FBG optical fiber sensor; the capacity change value data are estimated through a coulomb meter + EIS analyzer; and the cycle count data are collected by a main control chip in a BMS.

In an implementation manner, the number of lithium batteries $N = 40$.

S12: calculating the state of health of each of the lithium batteries at each cycle count based on the cyclic operation data of each of the lithium batteries, and constructing a state of health sequence of each of the lithium batteries.

S13: extracting an aging feature sequence of each of the lithium batteries based on the cyclic operation data of each of the lithium batteries.

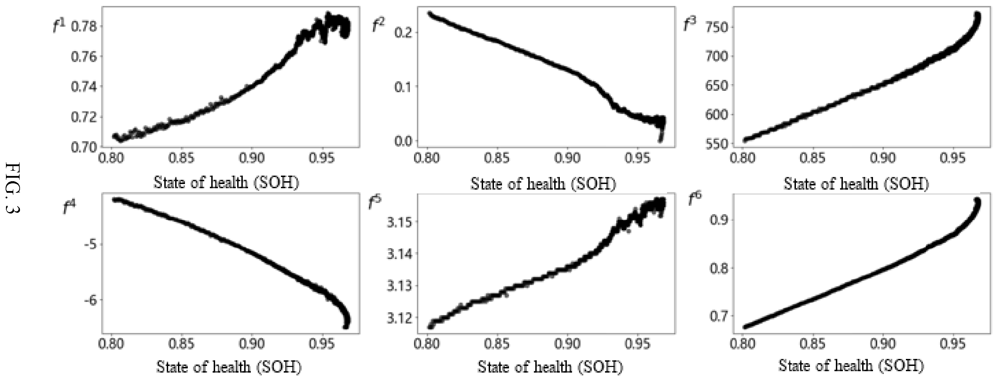

S14: as shown in FIG. 3, constructing the aging feature matrices of the plurality of lithium batteries based on the aging feature sequences of the plurality of lithium batteries and the state of health sequences of the plurality of lithium batteries. An Inspur NF5280M6 computing server is used to construct the aging feature matrices, with main computing hardware including: 2 x 24-core 21GHz5318Y24 processors; 4 x 32G memories; 4 x 4TB SATA hard drives; and 1 x NVIDIA RTX A6000-48G graphics card.

In an implementation manner, aging features include one or more of a coefficient of variation feature sequence $f^1$ of the capacity change value, an Euclidean distance feature sequence $f^2$ of the capacity change value, a height feature sequence $f^3$ of peaks in an incremental capacity curve, a voltage feature sequence $f^4$ corresponding to peaks in an incremental capacity curve, a height feature sequence $f^5$ of peaks in an incremental temperature curve, and a voltage feature sequence $f^6$ corresponding to peaks in an incremental temperature curve.

In an implementation manner, an aging feature matrix of a lithium battery is as follows:

$$D = [(f^1)^T, (f^2)^T, (f^3)^T, (f^4)^T, (f^5)^T, (f^6)^T, (soh)^T];$$

where $(\cdot)^T$ represents sequence transposition; and $D$ represents a matrix containing seven sequences.

During implementation, a state of health of a lithium battery = remaining capacity of the lithium battery / nominal capacity of the lithium battery; in this example, the nominal capacity of the lithium battery $Q_0$ = 280 ampere-hours.

S2: inputting the aging feature matrices of the plurality of lithium batteries into a Mamba model for training, and extracting a hidden state matrix sequence of each of the lithium batteries based on the trained Mamba model.

The step S2 includes the following steps.

S21: inputting the aging feature matrices of the plurality of lithium batteries into the Mamba model, and training the Mamba model using the aging feature sequences as a training set and the state of health sequences as labels to minimize a mean squared error (MSE) loss function until the MSE loss function between a model output and a true state of health sequence is < 0.01, to obtain the trained Mamba model.

S22: extracting a hidden state matrix of each cyclic charge-discharge segment of the lithium batteries from the trained Mamba model, and constructing the hidden state matrix sequence of each of the lithium batteries, where the cyclic charge-discharge segment includes operational data within a preset voltage interval extracted from the cyclic operation data of each of the lithium batteries, and the hidden state matrix sequence is a sequence composed of hidden state matrices of different cycle counts of the plurality of lithium batteries.

In an implementation manner, the preset voltage interval $[V_{lower}, V_{upper}]=[2.0,3.4]$, expressed in volts.

In practical applications, the Mamba model is an emerging sequence modeling architecture, essentially a structured state space model (SSM). By introducing a selection mechanism, it transforms a conventional time-invariant state space model into a time-varying model that changes with the input. The Mamba model overcomes the limitations of transformers in computational efficiency and long-sequence processing. Through the introduction of the concept of selective state space models, combined with hardware-aware algorithms and a simpler architecture, it achieves higher computational efficiency and stronger sequence modeling capabilities.

In an implementation manner, the Mamba model is as follows:

$$h_p = \bar{A}_p h_{p-1} + \bar{B}_p x_p;$$

$$y_p = C_p h_p;$$

where $x_p$, $y_p$, and $h_p$ serve as an input, output, and hidden state of the model, respectively; $x_p$ represents an aging feature of the lithium batteries at a $p^{th}$ cycle count; $y_p$ represents a state of health of the lithium batteries at the $p^{th}$ cycle count; $h_p$ represents the hidden state of the lithium batteries at the $p^{th}$ cycle count; $h_{p-1}$ represents a hidden state of the lithium batteries at a $(p-1)^{th}$ cycle count; $\overline{A}_p$, $\overline{B}_p$, and $C_p$ represent learnable parameter matrices; $p \in \{1,2, \cdots, P\}$; and $P$ represents a total cycle count of the lithium batteries.

In an implementation manner, the Mamba model is trained as follows.

A hidden state matrix $h_p$ of a $p^{th}$ cyclic discharge segment is extracted.

Various model parameters are randomly initialized.

For the cycle count (time step) $p$, $y_p$ is recursively calculated by the following formula to set a loss function:

$$\text{loss} = |y_p - D_{p7}|;$$

where $D_{p7}$ represents an element at a $p^{th}$ row and $7^{th}$ column of an aging feature matrix D, namely the SOH value of the $p^{th}$ cycle. Through backpropagation, the loss function is minimized and the model parameters ($h_p$, $\overline{A}_p$, $\overline{B}_p$, and $C_p$) are updated.

A hidden state matrix $h_p$ of the last cycle count (time step) p is extracted, namely the hidden state matrix $h_p$ of the $p^{th}$ cyclic discharge segment.

A hidden state matrix sequence $H = (h_p)_{1 \leq p \leq P}$ is constructed with the extracted hidden state matrices $h_p$ of all cycles.

S3: obtaining a cycle count sequence corresponding to a target cycle life prediction point of each of the lithium batteries through norm calculation and variational mode decomposition based on the hidden state matrix sequence of each of the lithium batteries, where the target cycle life prediction point is a prediction point with the highest correlation among candidate cycle life prediction points, where the candidate cycle life prediction points are prediction points in a hidden state matrix norm sequence curve of the lithium batteries obtained after the norm calculation that correlate with a cycle count sequence corresponding to a target state of health of the lithium batteries, where the cycle count sequence corresponding to the target state of health of the lithium batteries is indexed from the state of health sequences.

In an implementation manner, the target state of health is as follows:

$$O = \{0.8, 0.81, 0.82, 0.83, 0.84, 0.85, 0.86, 0.87, 0.88, 0.89, 0.9\}.$$

The step S3 includes the following steps.

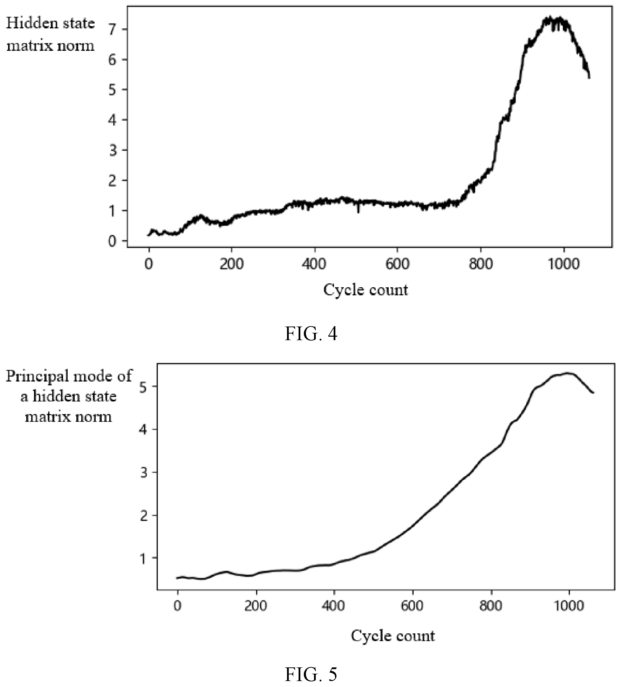

S31: as shown in FIG. 4, calculating a norm of a hidden state matrix of each cycle count in the hidden state matrix sequence of each of the lithium batteries respectively to obtain a hidden state matrix norm sequence of each of the lithium batteries.

In an implementation manner, the hidden state matrix norm sequence is calculated by the following formula:

$$G = (g_1, g_2, \cdots, g_p);$$

$$g_p = \sqrt{\sum_{i,j}(h_{p,ij})^2};$$

where $G$ represents the hidden state matrix norm sequence; $g_p$ represents a norm of a hidden state matrix of a $p^{th}$ cycle count; $h_{p,ij}$ represents a hidden state of an element at an $i^{th}$ row and $j^{th}$ column in the hidden state matrix of the $p^{th}$ cycle count of the lithium batteries; $p \in \{1,2, \cdots, P\}$; and $P$ represents a total cycle count of the lithium batteries.

S32: as shown in FIG. 5, performing the variational mode decomposition on the hidden state matrix norm sequence of each of the lithium batteries to extract a principal-mode hidden state matrix norm sequence of each of the lithium batteries.

S33: calculating cycle counts when principal-mode values reach each of the candidate cycle life prediction points based on the principal-mode hidden state matrix norm sequence of each of the lithium batteries.

S34: selecting a cycle count sequence corresponding to the prediction point with the highest correlation among the candidate cycle life prediction points as the cycle count sequence corresponding to the target cycle life prediction point of each of the lithium batteries.

In an implementation manner, the cycle count sequence corresponding to the target cycle life prediction point is calculated by the following formula:

$$\hat{b} = \underset{1 \leq b \leq |S|}{argmax} \left\{ \sum_{1 \leq a \leq |O|} \frac{\sum_{1 \leq i \leq N}(R_{ia}^O - \overline{R_a^O})(R_{ib}^S - \overline{R_b^S})}{\sqrt{\sum_{1 \leq i \leq N}(R_{ia}^O - \overline{R_a^O})^2}\sqrt{\sum_{1 \leq i \leq N}(R_{ib}^S - \overline{R_b^S})^2}} \right\};$$

where $\hat{b}$ represents the cycle count sequence corresponding to the target cycle life prediction point; *argmax*{·} represents an index of the maximum value in the sequence; $R_{ia}^O$ represents an $a$th column of a target state of health cycle count matrix $R^O$ of a lithium battery $i$; $R_{ib}^S$ represents a $b$th column of a cycle life prediction point cycle count matrix $R^S$ of the lithium battery $i$; $\overline{R_a^O}$ represents a mean value of the $a$th column of the matrix $R^O$; $\overline{R_b^S}$ represents a mean value of the $b$th column of the matrix $R^S$; $i \in \{1,2,\cdots, N\}$; $N$ represents the total number of the lithium batteries used; and S represents the number of the candidate cycle life prediction points.

In practical applications, for all of the $N$ batteries in the training set, a corresponding cycle count sequence $r^O$ when each battery cycles to the preset state of health (SOH) and a cycle count sequence $r^S$ corresponding to the candidate cycle life prediction points are extracted according to the steps S1-S4, thereby constructing a cycle count matrix $R^O$ corresponding to each of the batteries cycling to the preset state of health (SOH) and a cycle count sequence $R^S$ corresponding to the candidate cycle life prediction points, where the element $R_{ia}^O$ at the $i$th row and $a$th column of $R^O$ represents the corresponding cycle count when the lithium battery $i$ cycles to the $a$th element in the set O of to-be-predicted states of health (SOH); the element $R_{ib}^S$ at the $i$th row and $b$th column of $R^S$ represents the corresponding cycle count when the battery i cycles to the $b$th element in the set S of candidate life prediction points; i = 1,2,$\cdots$, $N$; a = 1,2,$\cdots$, $|O|$; b = 1,2$\cdots$,$|S|$; $|O|$ represents the number of elements in the set $O$; and $|S|$ represents the number of elements in the set S.

In practical applications, this method uses variational mode decomposition to perform modal separation on a hidden state matrix norm time series, so as to extract the principal mode as an analytical benchmark between an internal hidden state of battery aging and a cycle count, thereby reducing noise interference errors and improving robustness.

The variational mode decomposition method is used to perform modal decomposition on the hidden state matrix norm sequence, so as to obtain a finite number of intrinsic mode sequences of the hidden state matrix norm and one residual sequence.

$$VMD(G) = (l_1, l_2, \cdots, l_k, l_{res});$$

where $k$ represents the number of intrinsic mode sequences obtained through the variational mode decomposition; $l_k$ represents a $k$th intrinsic mode sequence obtained from the modal decomposition; $k$ = 1,2, $\cdots$ , $K$; $l_{res}$ represents the residual sequence; and $l_1$ is referred to as the principal mode.

The corresponding cycle count when the value of the principal mode $l_1$ reaches the candidate cycle life prediction points is calculated by the following formula:

$$p_b = argindex(l_1 = S_b);$$

where $S_b$ represents the $b$th element in the candidate cycle life prediction point set $S$; *argindex*($l_1 = S_b$) represents calculating the index position of the element meeting $l_1 = S_b$ in the sequence $l_1$, namely $p_b$; and for all $b$ = 1,2,$\cdots$,$|S|$, $p_b$ is calculated respectively to obtain the cycle count sequence $r^S$ corresponding to the candidate cycle life prediction points, where $|S|$ represents the number of elements in the set S. In this example, S = {2,2.5,3,3.5,4,4.5}, and $|S|$ = 6.

S4: constructing a linear relationship model for lithium battery lifetime prediction based on cycle count sequences corresponding to target states of health of all of the lithium batteries and cycle count sequences corresponding to target cycle life prediction points of all of the lithium batteries.

The step S4 includes the following steps.

S41: constructing a target state of health cycle count matrix based on the cycle count sequences corresponding to the target cycle life prediction points of all of the lithium batteries.

S42: constructing a target cycle life prediction point cycle count matrix based on the cycle count sequences corresponding to the target cycle life prediction points of all of the lithium batteries.

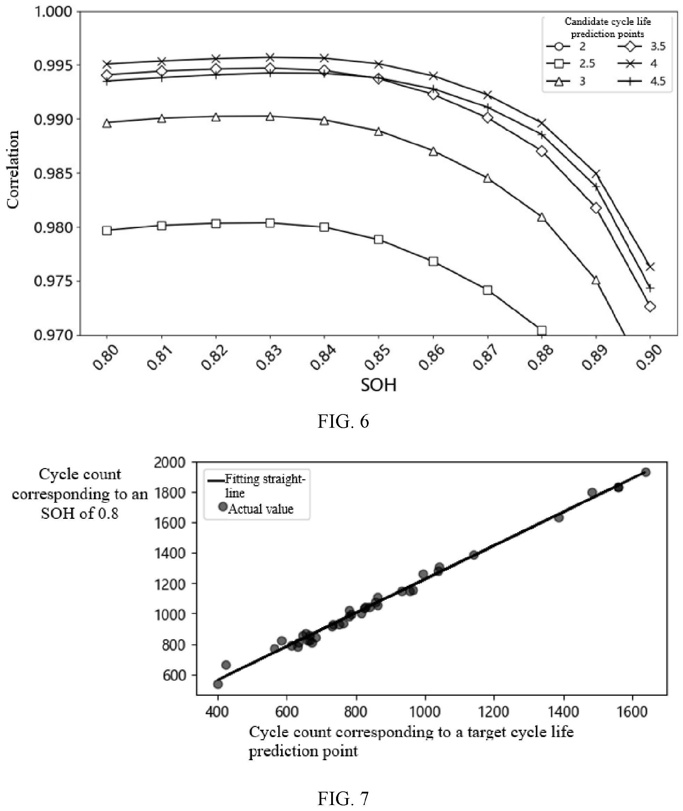

S43: as shown in FIGs. 6-7, obtaining the linear relationship model for lithium battery lifetime prediction through least-squares fitting based on the target state of health cycle count matrix and the target cycle life prediction point cycle count matrix.

In an implementation manner, the linear relationship model for lithium battery lifetime prediction is as follows:

$$R_a^O = \omega_a R_{\hat{b}}^S + \beta_a;$$

where $R_a^O$ represents an $a^{th}$ column of a target state of health cycle count matrix $R^O$; $R_{\hat{b}}^S$ represents a $\hat{b}$ sequence of a target cycle life prediction point cycle count matrix $R^S$; $\hat{b}$ represents the cycle count sequence corresponding to the target cycle life prediction point; and $\omega_a$ and $\beta_a$ represent a slope and intercept of a linear relationship model between $R_{\hat{b}}^S$ and $\beta_a$, respectively.

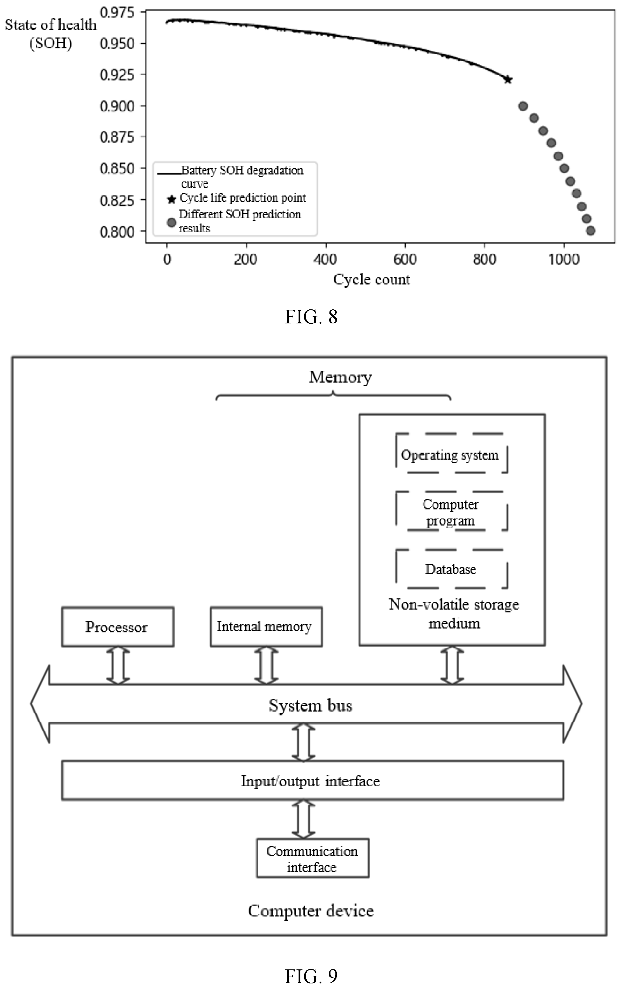

S5: as shown in FIG. 8, acquiring a cycle count sequence corresponding to a target cycle life prediction point of a to-be-predicted lithium battery, and inputting the same into the linear relationship model for lithium battery lifetime prediction to calculate a cycle count sequence corresponding to a target state of health of the to-be-predicted lithium battery.

In an implementation manner, during the process of acquiring the cycle count sequence corresponding to the target cycle life prediction point of the to-be-predicted lithium battery in the prediction phase, after extracting the principal mode sequence $l_1$ of the hidden state matrix norm of each lithium battery, it is also necessary to determine whether the value of the last element of the principal mode sequence $l_1$ of the hidden state matrix norm is less than $S_{\hat{b}}$. If so, it indicates that the current to-be-predicted lithium battery has not yet reached the cycle life prediction point, and more cycle data needs to be input until the value of the last element of the principal mode sequence $l_1$ of the hidden state matrix norm is greater than or equal to $S_{\hat{b}}$. Then, the corresponding cycle count when the value of the principal mode sequence of the hidden state matrix norm reaches the life prediction point $S_{\hat{b}}$ is calculated by the following formula:

$$p_{\hat{b}} = argindex(l_1 = S_{\hat{b}});$$

where $p_{\hat{b}}$ represents the index result after applying *argindex*($\cdot$) when the value of the sequence $l_1$ equals $S_{\hat{b}}$; $S_{\hat{b}}$ represents the target cycle life prediction point; and $\hat{b}$ represents its corresponding index in the set S.

The cycle count sequence corresponding to the target state of health of the to-be-predicted lithium battery is calculated by the following formula:

$$\hat{p} = \{\widehat{p_1}, \ \widehat{p_2}, ... \widehat{p_a}\};$$

$$\widehat{p_a} = \omega_a p_{\hat{b}} + \beta_a;$$

where $\hat{p}$ represents the cycle count sequence corresponding to the target state of health of the to-be-predicted lithium battery; $\omega_a$, $\beta_a$ represent parameters of the linear relationship model; $O_a$ represents the $a^{th}$ element in the target state of health (set) $O$; and for all $a = 1, 2, \cdots, |O|$.

By utilizing the cycle count sequence corresponding to the target state of health of the to-be-predicted lithium battery to adjust the battery's charge-discharge strategy, rapid capacity fading due to over-cycling is prevented. The predicted cycle count sequence can be used to plan the battery replacement time in advance, preventing sudden failures. Additionally, the remaining cycle count of the battery can be predicted to assess its suitability for echelon use, thereby maximizing resource value.

In practical applications, the present application has the following technical effects.

During the training phase, the present application extracts battery aging features from actual operational charge-discharge cycle data segments of the battery to construct a cycle count-based time series of battery aging features, uses the Mamba model to extract the internal hidden state matrix of battery aging from the time series of battery aging features, amplifies the variation patterns of the battery's hidden state with respect to cycle counts by calculating the hidden state matrix norm sequence, performs modal decomposition on the hidden state matrix norm sequence through variational mode decomposition and extracts the principal mode sequence, determines the battery cycle life prediction point through correlation analysis, establishes a linear relationship model and uses the least squares method to learn the parameters of the linear relationship model between the corresponding cycle count when the battery reaches the cycle life prediction point and the target state of health, and finally stores the learned parameters. During the prediction phase, by inputting the cycle data of the to-be-predicted battery and using the same method as that used in the training phase to calculate the principal mode sequence of the hidden state matrix norm, it determines whether the cycle life prediction condition is met by checking if the last value of the principal mode sequence of the hidden state matrix norm is greater than the cycle life prediction point determined in the training phase. If the cycle life prediction condition is met, the cycle count at which the cycle life prediction point is reached is input into the linear relationship model from the training phase, and the corresponding parameters are matched to complete the state of health (SOH) prediction.

Example 2: the present application further provides a computer system, which may be a server or a terminal and may have an internal structure shown in FIG. 9. The computer system includes a processor, a memory, an input/output interface (I/O), and a communication interface, where the processor, memory, and input/output interface are connected via a system bus, while the communication interface is connected to the system bus through the input/output interface; the processor is configured to provide computing and control capabilities; the memory includes a non-volatile storage medium and an internal memory, where the non-volatile storage medium stores an operating system, a computer program, and a database, while the internal memory provides an environment for running the operating system and the computer program stored in the non-volatile storage medium; the database is configured to store video tag processing data; the input/output interface is configured to exchange information between the processor and external devices; the communication interface is configured to communicate with external terminals via network connections; and the computer program is executed by the processor to implement the above-described Mamba model-based lithium battery lifetime prediction method.

Those skilled in the art can understand that the structure shown in FIG. 9 is only a block diagram of partial structure related to the solution of the present application, and does not constitute a limitation on the computer system to which the solution of the present application is applied. The computer system may include more or fewer components than those shown in the figure, or combine some components, or have a different component arrangement.

A person of ordinary skill in the art can understand that all or part of the processes in the above-described method embodiments can be completed by instructing relevant hardware through a computer program, where the computer program can be stored in a non-volatile computer-readable storage medium and can include the processes of the above-described method embodiments when executed. Here, any reference to a memory, database, or any other medium used in the embodiments provided in the present application may include at least one of a non-volatile and a volatile memory. The non-volatile memory may include a read-only memory (ROM), a magnetic tape, a floppy disk, a flash memory, an optical memory, a high-density embedded non-volatile memory, a resistive random-access memory (ReRAM), a magnetoresistive random-access memory (MRAM), a ferroelectric random-access memory (FRAM), a phase-change memory (PCM), or a graphene memory. The volatile memory may include a random-access memory (RAM) or an external cache memory, among others. By way of illustration rather than limitation, the RAM may take various forms, such as a static random-access memory (SRAM) or a dynamic random-access memory (DRAM).

The technical features of the above embodiments can be combined in any way. To simplify the description, not all possible combinations of the technical features in the above embodiments are described. However, as long as there is no contradiction in the combinations of these technical features, all possible combinations should be considered to fall within the scope of this specification.

Although the embodiments are provided to elaborate the principles and implementation manners of the present application, the descriptions of the aforementioned embodiments are merely intended to help understand the method and core concepts of the present application. Meanwhile, for a person of ordinary skill in the art, variations in specific implementation manners and application scopes may occur based on the concepts of the present application. In conclusion, the content of this specification should not be construed as limiting the present application.

## Claims

1. A Mamba model-based lithium battery lifetime prediction method, comprising the following steps:

   acquiring aging feature matrices of a plurality of lithium batteries, wherein the aging feature matrices comprise: state of health sequences and aging feature sequences, wherein the state of health sequences are sequences formed by a state of health of each of the lithium batteries at each cycle count;
   inputting the aging feature matrices of the plurality of lithium batteries into a Mamba model for training, and extracting a hidden state matrix sequence of each of the lithium batteries based on the trained Mamba model;
   obtaining a cycle count sequence corresponding to a target cycle life prediction point of each of the lithium batteries through norm calculation and variational mode decomposition based on the hidden state matrix sequence of each of the lithium batteries, wherein the target cycle life prediction point is a prediction point with the highest correlation among candidate cycle life prediction points, wherein the candidate cycle life prediction points are prediction points in a hidden state matrix norm sequence curve of the lithium batteries obtained after the norm calculation that correlate with a cycle count sequence corresponding to a target state of health of the lithium batteries, wherein the cycle count sequence corresponding to the target state of health of the lithium batteries is indexed from the state of health sequences;
   constructing a linear relationship model for lithium battery lifetime prediction based on cycle count sequences corresponding to target states of health of all of the lithium batteries and cycle count sequences corresponding to target cycle life prediction points of all of the lithium batteries; and

acquiring a cycle count sequence corresponding to a target cycle life prediction point of a to-be-predicted lithium battery, and inputting the same into the linear relationship model for lithium battery lifetime prediction to calculate a cycle count sequence corresponding to a target state of health of the to-be-predicted lithium battery.

2. The Mamba model-based lithium battery lifetime prediction method of claim 1, wherein the step of acquiring the aging feature matrices of the plurality of lithium batteries comprises:

acquiring cyclic operation data of the plurality of lithium batteries, wherein the cyclic operation data at least comprise: voltage, temperature, capacity change value, and cycle count data at different sampling times; calculating the state of health of each of the lithium batteries at each cycle count based on the cyclic operation data of each of the lithium batteries, and constructing a state of health sequence of each of the lithium batteries; extracting an aging feature sequence of each of the lithium batteries based on the cyclic operation data of each of the lithium batteries; and constructing the aging feature matrices of the plurality of lithium batteries based on the aging feature sequences of the plurality of lithium batteries and the state of health sequences of the plurality of lithium batteries.

3. The Mamba model-based lithium battery lifetime prediction method of claim 1, wherein the step of inputting the aging feature matrices of the plurality of lithium batteries into the Mamba model for training, and extracting the hidden state matrix sequence of each of the lithium batteries based on the trained Mamba model comprises:

inputting the aging feature matrices of the plurality of lithium batteries into the Mamba model, and training the Mamba model using the aging feature sequences as a training set and the state of health sequences as labels, to obtain the trained Mamba model; and extracting a hidden state matrix of each cyclic charge-discharge segment of the lithium batteries from the trained Mamba model, and constructing the hidden state matrix sequence of each of the lithium batteries, wherein the cyclic charge-discharge segment comprises operational data within a preset voltage interval extracted from the cyclic operation data of each of the lithium batteries, and the hidden state matrix sequence is a sequence composed of hidden state matrices of different cycle counts of the plurality of lithium batteries.

4. The Mamba model-based lithium battery lifetime prediction method of claim 1, wherein the step of obtaining the cycle count sequence corresponding to the target cycle life prediction point of each of the lithium batteries through the norm calculation and the variational mode decomposition based on the hidden state matrix sequence of each of the lithium batteries comprises:

calculating a norm of a hidden state matrix of each cycle count in the hidden state matrix sequence of each of the lithium batteries respectively to obtain a hidden state matrix norm sequence of each of the lithium batteries; performing the variational mode decomposition on the hidden state matrix norm sequence of each of the lithium batteries to extract a principal-mode hidden state matrix norm sequence of each of the lithium batteries; calculating cycle counts when principal-mode values reach each of the candidate cycle life prediction points based on the principal-mode hidden state matrix norm sequence of each of the lithium batteries; and selecting a cycle count sequence corresponding to the prediction point with the highest correlation among the candidate cycle life prediction points as the cycle count sequence corresponding to the target cycle life prediction point of each of the lithium batteries.

5. The Mamba model-based lithium battery lifetime prediction method of claim 4, wherein the hidden state matrix norm sequence is calculated by the following formula:

$$G = (g_1, g_2, \cdots, g_p);$$

$$g_p = \sqrt{\sum_{i,j}(h_{p,ij})^2};$$

wherein G represents the hidden state matrix norm sequence; $g_p$ represents a norm of a hidden state matrix of a $p^{th}$ cycle count; $h_{p,ij}$ represents a hidden state of an element at an $i^{th}$ row and $j^{th}$ column in the hidden state matrix of the $p^{th}$ cycle count of the lithium batteries; $p \in \{1,2,\cdots, P\}$; and P represents a total cycle count of the lithium batteries.

6. The Mamba model-based lithium battery lifetime prediction method of claim 4, wherein the cycle count sequence corresponding to the target cycle life prediction point is calculated by the following formula:

$$\hat{b} = \underset{1\leq b\leq|S|}{arg\,max}\left\{\sum_{1\leq a\leq|O|}\frac{\sum_{1\leq i\leq N}(R_{ia}^{O}-\overline{R_{a}^{O}})(R_{ib}^{S}-\overline{R_{b}^{S}})}{\sqrt{\sum_{1\leq i\leq N}(R_{ia}^{O}-\overline{R_{a}^{O}})^{2}}\sqrt{\sum_{1\leq i\leq N}(R_{ib}^{S}-\overline{R_{b}^{S}})^{2}}}\right\};$$

wherein $\hat{b}$ represents the cycle count sequence corresponding to the target cycle life prediction point; *argmax*{·} represents an index of the maximum value in the sequence; $R_{ia}^{O}$ represents an $a$th column of a target state of health cycle count matrix $R^{O}$ of a lithium battery $i$; $R_{ib}^{S}$ represents a $b$th column of a cycle life prediction point cycle count matrix $R^{S}$ of the lithium battery $i$; $\overline{R_{a}^{O}}$ represents a mean value of the $a$th column of the matrix $R^{O}$; $\overline{R_{b}^{S}}$ represents a mean value of the $b$th column of the matrix $R^{S}$; $i \in \{1,2, \cdots , N\}$; $N$ represents the total number of the lithium batteries used; and $S$ represents the number of the candidate cycle life prediction points.

7. The Mamba model-based lithium battery lifetime prediction method of claim 1, wherein the step of constructing the linear relationship model for lithium battery lifetime prediction based on the cycle count sequences corresponding to the target states of health of all of the lithium batteries and the cycle count sequences corresponding to the target cycle life prediction points of all of the lithium batteries comprises:

constructing a target state of health cycle count matrix based on the cycle count sequences corresponding to the target cycle life prediction points of all of the lithium batteries;
constructing a target cycle life prediction point cycle count matrix based on the cycle count sequences corresponding to the target cycle life prediction points of all of the lithium batteries; and
obtaining the linear relationship model for lithium battery lifetime prediction through least-squares fitting based on the target state of health cycle count matrix and the target cycle life prediction point cycle count matrix.

8. The Mamba model-based lithium battery lifetime prediction method of claim 1, wherein the Mamba model is as follows:

$$h_{p} = \bar{A}_{p}h_{p-1} + \bar{B}_{p}x_{p};$$

$$y_{p} = C_{p}h_{p};$$

wherein $x_{p}$, $y_{p}$, and $h_{p}$ serve as an input, output, and hidden state of the model, respectively; $x_{p}$ represents an aging feature of the lithium batteries at a $p$th cycle count; $y_{p}$ represents a state of health of the lithium batteries at the $p$th cycle count; $h_{p}$ represents the hidden state of the lithium batteries at the $p$th cycle count; $h_{p-1}$ represents a hidden state of the lithium batteries at a $(p-1)$th cycle count; $\bar{A}_{p}$, $\bar{B}_{p}$, and $C_{p}$ represent learnable parameter matrices; $p \in \{1,2, \cdots , P\}$; and P represents a total cycle count of the lithium batteries.

9. The Mamba model-based lithium battery lifetime prediction method of claim 1, wherein the linear relationship model for lithium battery lifetime prediction is as follows:

$$R_{a}^{O} = \omega_{a}R_{\hat{b}}^{S} + \beta_{a};$$

wherein $R_{a}^{O}$ represents an $a$th column of a target state of health cycle count matrix $R^{O}$; $R_{\hat{b}}^{S}$ represents a $\hat{b}$ sequence of a target cycle life prediction point cycle count matrix $R^{S}$; $\hat{b}$ represents the cycle count sequence corresponding to the target cycle life prediction point; and $\omega_{a}$ and $\beta_{a}$ represent a slope and intercept of a linear relationship model between $R_{\hat{b}}^{S}$ and $\beta_{a}$, respectively.

10. A computer system, comprising: a memory, a processor, and a computer program stored on the memory and executable on the processor, wherein the processor executes the computer program to implement the Mamba model-based lithium battery lifetime prediction method of any one of claims 1-9.

S1

Acquire aging feature matrices of a plurality of lithium batteries

S2

Input the aging feature matrices of the plurality of lithium batteries into a Mamba model for training, and extract a hidden state matrix sequence of each of the lithium batteries based on the trained Mamba model

S3

Obtain a cycle count sequence corresponding to a target cycle life prediction point of each of the lithium batteries through norm calculation and variational mode decomposition based on the hidden state matrix sequence of each of the lithium batteries

S4

Construct a linear relationship model for lithium battery lifetime prediction based on cycle count sequences corresponding to target states of health of all of the lithium batteries and cycle count sequences corresponding to target cycle life prediction points of all of the lithium batteries

S5

Acquire a cycle count sequence corresponding to a cycle life prediction point of a to-be-predicted lithium battery, and input the same into the linear relationship model for lithium battery lifetime prediction to calculate a cycle count sequence corresponding to a target state of health of the to-be-predicted lithium battery

FIG. 1

FIG. 2

FIG. 3

Hidden state matrix norm

Cycle count

FIG. 4

Principal mode of a hidden state matrix norm

Cycle count

FIG. 5

FIG. 6

FIG. 7

FIG. 8

FIG. 9

**TRANSLATION**

### INTERNATIONAL SEARCH REPORT

| International application No. |
| --- |
| **PCT/CN2025/091752** |

| A. | CLASSIFICATION OF SUBJECT MATTER |
| --- | --- |

G01R31/392(2019.01)i; G01R31/367(2019.01)i

According to International Patent Classification (IPC) or to both national classification and IPC

| B. | FIELDS SEARCHED |
| --- | --- |

Minimum documentation searched (classification system followed by classification symbols)

IPC:G01R31

Documentation searched other than minimum documentation to the extent that such documents are included in the fields searched

Electronic data base consulted during the international search (name of data base and, where practicable, search terms used)

CNTXT, CNABS, CNKI, 万方, WANFANG: mamba模型, 电池寿命, 电池, 老化, 特征矩阵, 特征序列, 循环圈数; VEN, USTXT, WOTXT, EPTXT: mamba, model, battery life, battery, aging, feature matrix, feature sequence, loop number

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 119247194 A (YUNCHU NEW ENERGY TECHNOLOGY CO., LTD.) 03 January 2025 (2025-01-03) <br> description, paragraphs 22-95, and figures 1-9 | 1-10 |
| A | CN 115792676 A (EVE ENERGY CO., LTD.) 14 March 2023 (2023-03-14) <br> description, paragraphs 34-104, and figures 1-8 | 1-10 |
| A | CN 118607359 A (NINGBO UNIVERSITY) 06 September 2024 (2024-09-06) <br> entire document | 1-10 |
| A | CN 118444159 A (HANGZHOU DIANZI UNIVERSITY) 06 August 2024 (2024-08-06) <br> entire document | 1-10 |
| A | US 2013289896 A1 (NORTHEASTERN UNIVERSITY) 31 October 2013 (2013-10-31) <br> entire document | 1-10 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **17 July 2025** | **18 August 2025** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2025/091752**

| Patent document cited in search report | | | Publication date (day/month/year) | Patent family member(s) | | | Publication date (day/month/year) |
|---|---|---|---|---|---|---|---|
| CN | 119247194 | A | 03 January 2025 | CN | 119247194 | B | 18 March 2025 |
| CN | 115792676 | A | 14 March 2023 | None | | | |
| CN | 118607359 | A | 06 September 2024 | None | | | |
| CN | 118444159 | A | 06 August 2024 | CN | 118444159 | B | 15 April 2025 |
| US | 2013289896 | A1 | 31 October 2013 | WO | 2012100153 | A1 | 26 July 2012 |
| | | | | US | 9921187 | B2 | 20 March 2018 |

Form PCT/ISA/210 (patent family annex) (July 2022)

**REFERENCES CITED IN THE DESCRIPTION**

**Patent documents cited in the description**

- CN 202411785131